(19) Europäisches Patentamt
European Patent Office
Office européen des brevets

(11) **EP 1 986 453 B1**

(12) **EUROPEAN PATENT SPECIFICATION**

(45) Date of publication and mention
of the grant of the patent:
**08.07.2009 Bulletin 2009/28**

(51) Int Cl.:
**G01R 29/00** (2006.01)

(21) Application number: **07106743.3**

(22) Date of filing: **23.04.2007**

(54) **Method and system for conducting specific absorption rate testing of a mobile communication device**

Verfahren und System zum Durchführen von Prüfungen der spezifischen Absorptionsrate bei einer mobilen Kommunikationsvorrichtung

Procédé et système pour effectuer un test de taux d'absorption spécifique dans un dispositif de communication mobile

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(43) Date of publication of application:
**29.10.2008 Bulletin 2008/44**

(73) Proprietor: **Research In Motion Limited**
**Waterloo, Ontario N2L 3W8 (CA)**

(72) Inventors:
• **Qi, Yihong**
**St. Agatha Ontario N0B 2L0 (CA)**
• **Man, Ying Tong**
**Waterloo Ontario N2V 2V8 (CA)**
• **Jarmuszewski, Perry**
**Waterloo Ontario N2V 2R6 (CA)**
• **Attayi, Daoud S.**
**Waterloo Ontario N2V 2N6 (CA)**
• **Cardinal, Paul Gerard Giles**
**Waterloo Ontario N2J 4Y7 (CA)**

(74) Representative: **Rickard, David John**
**Ipulse**
**26 Mallinson Road**
**London**
**SW11 1BP (GB)**

(56) References cited:
**EP-A- 1 455 193**

• **SEABURY DAVID ET AL: "An Update On SAR Standards And the Basic Requirements for SAR Assessment" INTERNET CITATION, [Online] 6 April 2005 (2005-04-06), XP002435692 Retrieved from the Internet: URL:http://www.ets-lindgren.com/pdf/sar_lo .pdf> [retrieved on 2007-05-29]**
• **OGAWA K ET AL: "A high-precision real human phantom for EM evaluation of handheld terminals in a talk situation" IEEE ANTENNAS AND PROPAGATION SOCIETY INTERNATIONAL SYMPOSIUM. 2001 DIGEST. APS. BOSTON, MA, JULY 8 - 13, 2001, NEW YORK, NY : IEEE, US, vol. VOL. 1 OF 4, 8 July 2001 (2001-07-08), pages 68-71, XP010564033 ISBN: 0-7803-7070-8**
• **LUNDMARK M ET AL: "A solid hand phantom for mobile phones and results of measurements in reverberation chamber" ANTENNAS AND PROPAGATION SOCIETY SYMPOSIUM, 2004. IEEE MONTEREY, CA, USA JUNE 20-25, 2004, PISCATAWAY, NJ, USA,IEEE, vol. 1, 20 June 2004 (2004-06-20), pages 719-722, XP010721146 ISBN: 0-7803-8302-8**

## Description

The described embodiments relate generally to methods and systems for conducting specific absorption rate (SAR) testing of a mobile communication device. In particular, the methods and systems involve the use of a simulated hand to support the mobile communication device during the testing.

Government safety standards strictly regulate the field strength of mobile communications devices. The regulations specify a permissible specific absorption rate, the safe amount of radio frequency energy which a person can safely tolerate. Manufacturers must ensure that their devices comply with such standards; regulations also specify the testing requirements and procedures to be used, before new models are approved for public use.

In order to satisfy the testing requirements, the testing results must be repeatable. Measurements obtained during SAR testing have a certain amount of inherent uncertainty. Accordingly, the regulations specify that the SAR measurement uncertainty must fall within a specific tolerance, for example 20%.

However, the antennae and housing configurations of the device may result in different interactions with the standard supporting members used in standard SAR testing. As a result, these different configurations may affect the uncertainty of standard SAR measurement techniques. Reducing this SAR measurement uncertainty can be important for helping manufacturers in device development.

David Seabury et al have provided "An Update On SAR Standards And The Basic Requirements For SAR Assessment" XP002435692. Test systems should include a simulated human head with suitable positioning components. A probe should measure the radiation field within the simulated head. A specific example of "A High Precision Real Human Phantom for EM Evaluation of Handheld Terminals in a Talk Situation" is described by Ogawa et al XP 010564033.

## GENERAL

The described embodiments relate generally to methods and systems for conducting SAR testing of a mobile communication device. Certain embodiments generally make use of a simulated hand to support the mobile communication device during the testing.

In one aspect there is provided a system for conducting specific absorption rate testing of a mobile communication device, comprising: a simulated human body part; a support positioned proximate to the simulated human body part for supporting the mobile communication device during the testing; a probe positioned within the simulated human body part; and a processor operatively coupled to the probe and configured to determine a field strength of a field within the simulated human body part, the field radiated by the mobile communication device.

The system may comprise: a simulated head and a simulated hand positioned proximate to the simulated head for supporting the mobile communication device during the testing.

The field may comprise an electric field at radio or microwave frequency and the probe may be configured for electric and/or microwave and/or radio frequency field sensing.

The simulated hand may comprise a material having dielectric properties approximating average dielectric properties, such as an average dialectic constant, of a human hand.

The system may further comprises a communication unit responsive to the processor to communicate with the mobile communication device and to cause the mobile communication device to radiate the field.

The simulated head may be positioned proximate the mobile communication device and on an opposite side of the mobile communication device to the simulated hand.

The simulated head may comprise a material having dielectric properties approximating average dielectric properties, such as an average dialectic constant, of a human head. The material may be a liquid.

Other embodiments may use a simulated hand for conducting specific absorption rate testing of a mobile communication device, in which the simulated hand supports the mobile communication device during testing, wherein the simulated hand comprises a material having a dielectric constant approximating an average dielectric constant of a human hand.

Other embodiments may use a simulated hand and a simulated head for conducting specific absorption rate testing of a mobile communication device during the testing. The simulated hand supports the mobile communication device and the simulated head may be positioned on an opposite side of the mobile communication device to the simulated hand during testing. In such embodiments, the simulated hand comprises a material having a dielectric constant approximating an average dielectric constant of a human hand, and the simulated head comprises a material having a dielectric constant approximating an average dielectric constant of a human head.

The mobile communication device may be positioned proximate the simulated head so that the simulated head is located on an opposite side of the mobile communication device to the simulated hand. The field may comprise an electric field at radio or microwave frequency and the determining may comprise electric and/or radio frequency field sensing.

Yet other embodiments may relate to a system for conducting specific absorption rate testing of a mobile communication device, comprising a simulated torso; a support positioned proximate to the simulated torso for supporting the mobile communication device during the testing; a probe positioned within the simulated torso. The simulated torso may comprise a material having dielectric properties approximating average dielectric properties of a human torso. In certain embodiments, the support comprises a platform mounted to a platform support, and wherein the surface area of the platform support in contact with the platform is no greater than 40% of the horizontal surface area of the platform.

Further embodiments may relate to the use of a simulated torso for conducting specific absorption rate testing of a mobile communication device, wherein a probe is positioned within the simulated torso during testing, and wherein the simulated torso comprises a material having dielectric properties approximating average dielectric properties of a human torso.

**BRIEF DESCRIPTION OF THE DRAWINGS**

The embodiments are described in further detail below, by way of example, with reference to the accompanying drawings, in which;

FIG. 1 is a block diagram of a system for conducting SAR testing of a mobile communication device;
FIG. 2 is a perspective view of a part of an embodiment of the system of FIG. 1;
FIG. 3 is a perspective view of a part of an embodiment of the system of FIG. 1, showing a mobile communication device in relation to a simulated head and a simulated hand;
FIG. 4 is a flowchart of a method for conducting SAR testing of a mobile communication device;
FIG. 5 is a block diagram of an alternate embodiment of a system for conducting SAR testing of a mobile communication device;
FIG. 6 is a side schematic view of a part of an embodiment of the system of FIG. 5, showing a mobile communication device in relation to a simulated torso and a support; and
FIG. 7 is a flowchart of a further method of conducting SAR testing of a mobile communication device.

**DESCRIPTION OF PREFERRRED EMBODIMENTS**

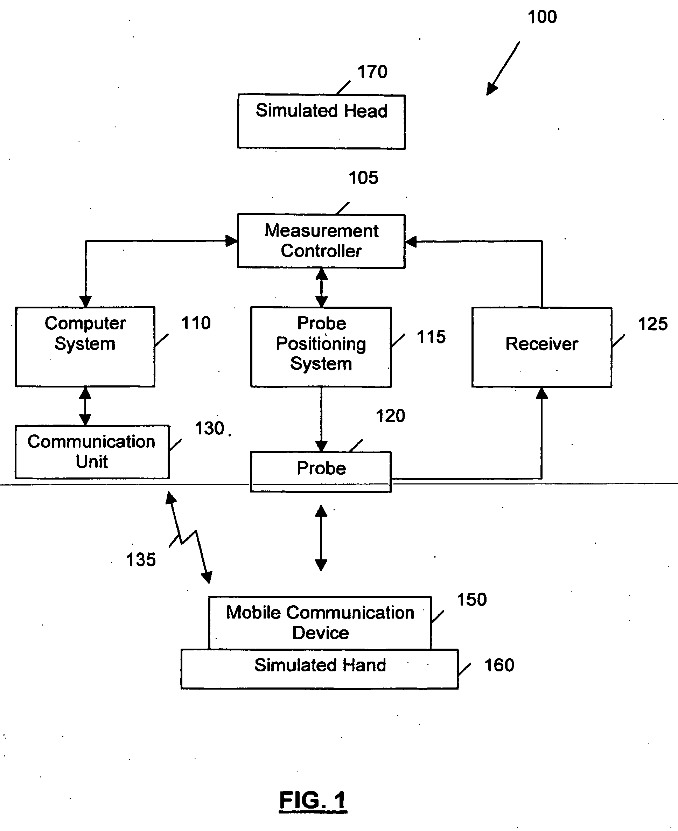

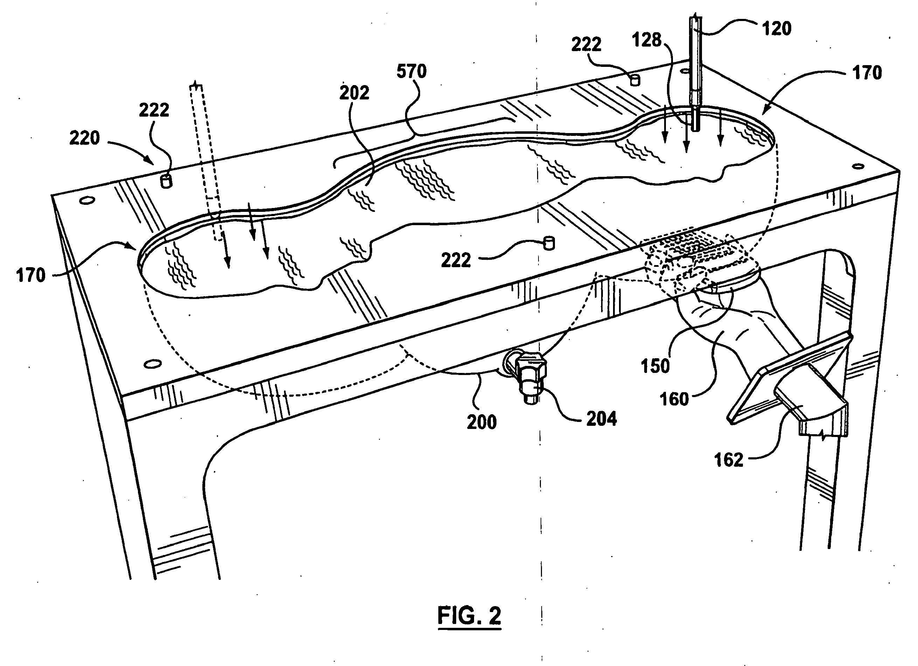

Referring jointly now to FIG. 1 and 2, there is shown a system 100 for conducting SAR testing of a mobile communication device 150. System 100 comprises a suitably programmed measurement controller/processor 105, computer system 110, and positioning system 115, as well as a probe 120, receiver 125, communication unit 130, simulated hand 160 and simulated head 170. The measurement controller 105 communicates with probe positioning system 115 to cause probe 120 to be positioned in a sequence of spaced locations within the simulated head and relative to the mobile communication device 150.

Probe positioning system 115 may be a robotic arm suitable for precision movement and positioning of a probe tip 128 (see FIG. 2).

One example of a measurement controller 105 is the commercially available DASY4 system marketed by Schmid & Partner Engineering AG. This system includes suitable software for performing the SAR testing (including controlling probe positioning system 115) and suitable equipment to serve as probe 120. A suitable probe positioning system 115 may comprise a robot arm manufactured by STAUBLI Unimation, for example.

Mobile communication device 150 may be any suitable device capable of wireless transmission of signals in a cellular network. The mobile communication device 150 may comprise additional features and functions, such as provisioning for electronic mail communication, or other functions to be performed on the device or with the aid of a wirelessly accessed network.

An output of probe 120 is connected to receiver 125. Receiver 125 receives a measurement signal from the output of the probe 120 and the receiver 125 conditions the measurement signal as necessary before providing a corresponding output to measurement controller 105. Measurement controller 105 receives the output of probe 120 via receiver 125 and determines the field strength of the electric field sensed by probe 120 based on that output.

As will be understood, SAR is calculated from measured E-field by the following formula:

$$\text{EQ. 1: } \quad SAR = |E|^2 \sigma/\rho$$

where |E| is the magnitude of the measured or computed RMS (root means squared) electric field, $\sigma$ is the conductivity and $\rho$ is the mass density of the tissue-equivalent media. SAR is a measure of the rate of energy absorption per unit mass at a specific location in the tissue media. SAR may be expressed in units such as watts/kg.

Because the electric field strength is proportional to the power and the power is proportional to the square of the voltage in a sensing circuit of the probe 120, the field strength can be calculated, given a sensed voltage or current through a known resistance in the sensing circuit in probe 120. Accordingly, measurement controller 105 can determine the field strength of a field emitted from mobile communication device 150 based on a voltage output, for example, from the sensing circuit in probe 120.

In order to conduct the SAR testing, it is necessary to have mobile communication device 150 transmit a signal in the same way that it would during wireless communication over a cellular connection. Communication unit 130 is manually caused to "place a call" to mobile communication device 150. The call made from communication unit 130 to mobile communication device 150 is established over a communication link 135, which persists during the SAR testing. Communication unit 130 is configured to transmit a particular test signal to mobile communication device 150 to cause it to transmit at maximum power, pursuant to SAR testing protocols.

Computer system 110 may provide a user interface (not shown) including a display and suitable software for displaying results of the SAR testing to an interested person. Further, computer system 110 may comprise a suitable memory (not shown) or database (not shown) for storing the results of the SAR testing.

During the SAR testing, mobile communication device 150 is supported in relation to the simulated head 170 by simulated hand 160. This supporting relation of simulated hand 160 to mobile communication device 150 mimics the use of a human hand to hold the mobile communication device 150 during its operation (i.e. as if the mobile communication device 150 were being held up to the human ear). Accordingly, the simulated hand is formed in a fixed position for holding the mobile communication device so that the thumb lies along a right side of the device (as viewed from the front), the palm supports the back of the device and the third, fourth and fifth digits support the left side of the device. An example form of simulated hand 160 and head 170 is shown in FIG. 2, which is described further below.

The simulated hand 160 is formed of a synthetic material having dielectric properties, including the dielectric constant and conductivity of the material, that are substantially constant throughout the material and that approximate the average dielectric properties of a human hand, including tissue and bones. For example, the simulated hand 160 may have a dielectric constant in the range of about 37 for low band frequencies to about 46 for high band frequencies. The conductivity of the simulated hand 160 may be about 0.85 s/m for low band frequencies up to about 2.46 s/m for high band frequencies.

An example of a suitable simulated hand is the hand phantom available from Microwave Consultants Ltd., London, England. Suitable simulated hands may be made to conform to CTIA and FCC standards for testing of wireless devices.

As shown in FIG. 2, mobile communication device 150 is supported by simulated hand 160. In turn, simulated hand 160 is connected to and supported by a support stand 162 that is movable through at least one, and optionally two or three, degrees of freedom. Support stand 162 enables suitable positioning of mobile communication device 150 relative to simulated head 170 when supported by simulated hand 160.

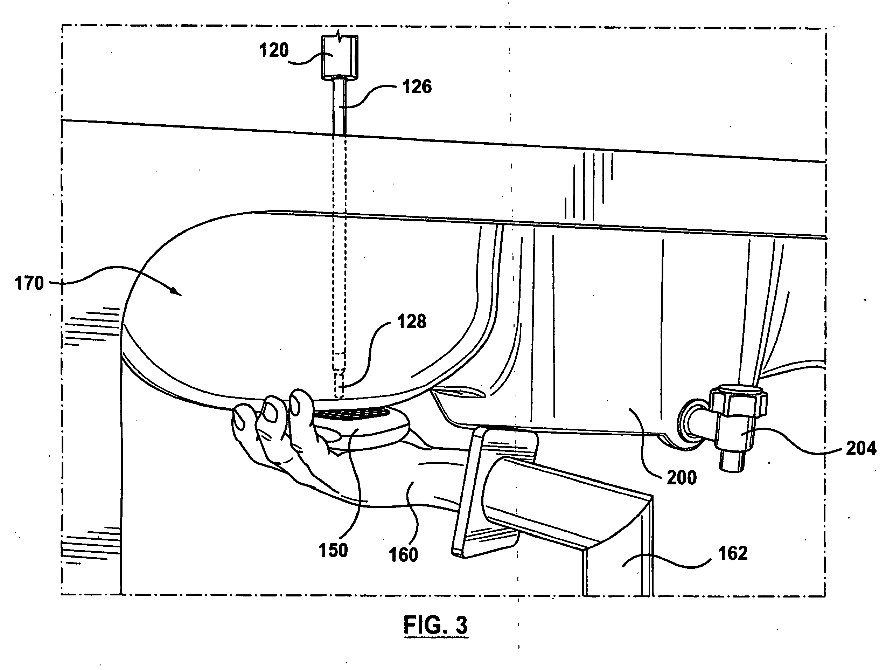

Simulated head 170 is shown and described below in further detail in relation to FIGS. 2 and 3. Simulated head 170 is situated above mobile communication device 150 while the mobile communication device 150 is supported below by simulated hand 160. Probe 120 is positioned within the simulated head 170. Simulated head 170 may be similar to existing commercially available arrangements employed for SAR testing.

Simulated head 170 comprises a specially shaped tank 200 for containing a volume of liquid 202. Tank 200 is supported by a table-like structure so as to be stable and stationary. Tank 200 has walls contoured so as to resemble, at opposed longitudinal ends of tank 200, a left and right head shape, as viewed upwardly from below tank 200. Tank 200 may be open to the air where its walls meet with a planar top surface of the table-like structure. Alternatively, tank 200 may be substantially enclosed so that liquid 202 is substantially covered, while being provided with access ports to allow probe 120 to access the left and right head shape at the respective longitudinal ends of the tank 200. Liquid 202 may be drained from tank 200 by a drainage valve 204, as required.

Liquid 202 may be any suitable liquid having substantially uniform dielectric properties, including dielectric constant and conductivity, that approximate the average dielectric properties of a human head, including bone and other tissue. Examples of such suitable liquids include mixtures of de-ionized water, sugar, salt, cellulose, preservative and diethylene-glycol monobutyl ether (DGBE). The particular characteristics and proportions of such ingredients of liquids suitable for simulating head tissue will be known to those skilled in the art of SAR testing, as will suitable methods of preparation of such liquids.

Tank 200 may hold approximately 25 liters of head tissue simulating liquid 202. Target dielectric properties for the head tissue simulating liquid 202 at frequencies between 300 MHz and 3 GHz are defined in the standards for compliance testing, such as CENELEC EN50361, Supplement C to OET Bulletin 65, IEEE P1528, for example.

Tank 200 is also preferably provided with a reference system 220 having a plurality of reference markers or indicia 222. Such reference markers 222 are used in calibrating the probe positioning system 115 relative to the tank 200 and simulated head 170. As will be understood, the reference markers 222 are "taught" to the probe positioning system (for example, by moving the probe tip 128 to each marker 222) and establish the transformation between the coordinate system utilized by the measurement controller 105 and probe positioning system 115, and the real world coordinates of the tank 200.

The reference system 220 also includes communication device reference markers (not shown) on the underside of the tank 200, for accurately positioning the audio output of mobile communication device 150 relative to a simulated head 170 and reference markers 222. The communication device positioning markers may comprise a longitudinal line running the length of the tank 200 and running down the middle of the simulated heads 170. The communication device markers may also comprise a lateral line for each head 170 running through the head's 170 mid-point. The intersection of the longitudinal and lateral lines indicate the intended location for accurately positioning the audio output of mobile communication device 150 for the SAR testing. Alternatively, the communication device positioning markers may comprise a notch, ridge, or crosshairs, for example.

During SAR testing using simulated head 170, mobile communication device 150 is positioned beneath the head 170, while supported by simulated hand 160. Thus, mobile communication device 150 is positioned between (a left or right side of) simulated head 170 and simulated hand 160 in a manner that mimics the position of mobile communication device 150 when held to a person's ear.

As shown in FIG. 2, mobile communication device 150 and simulated hand 160 are positioned relative to simulated head 170 by positioning and adjustment of support stand 162, to which simulated hand 160 is connected or attached.

As shown in FIG. 2, probe 120 is positioned relative to mobile communication device 150 by lowering probe 120 down into simulated head 170 so that probe tip 128 can be positioned at one or more positions relative to the audio output of mobile communication device 150.

FIG. 3 shows a partial side view in perspective of simulated head 170, with mobile communication device 150 positioned/supported in simulated hand 160 beneath a right head portion of simulated head 170. Probe 120 is shown in FIG. 3 as extending downwardly toward mobile communication device 150, so that probe tip 128 is positioned proximate the audio output of mobile communication device 150.

FIG. 3 also shows probe 120 positioned so as to have a shaft 126 pending downwardly toward probe tip 128 at its lower end, with probe tip 128 positioned within the simulated head 170 and vertically above the mobile communication device 150. In this position, probe 120 can be used to measure a a field strength. The vertical and lateral position of the probe 120 (and probe tip 128) may be controlled by probe positioning system 115 according to SAR testing requirements.

Following use of probe 120 to sense a field strength at one position (relative to the indicia 222), probe 120 may be subsequently moved horizontally and vertically by probe positioning system 115 to a plurality of alternate positions by pre-programmed movement of probe 120 by probe positioning system 115. Field strength readings may be taken at each position. The probe positioning system 115 may be programmed to perform a horizontal area scan to determine a "peak" field strength, followed by a volume or three dimensional scan.

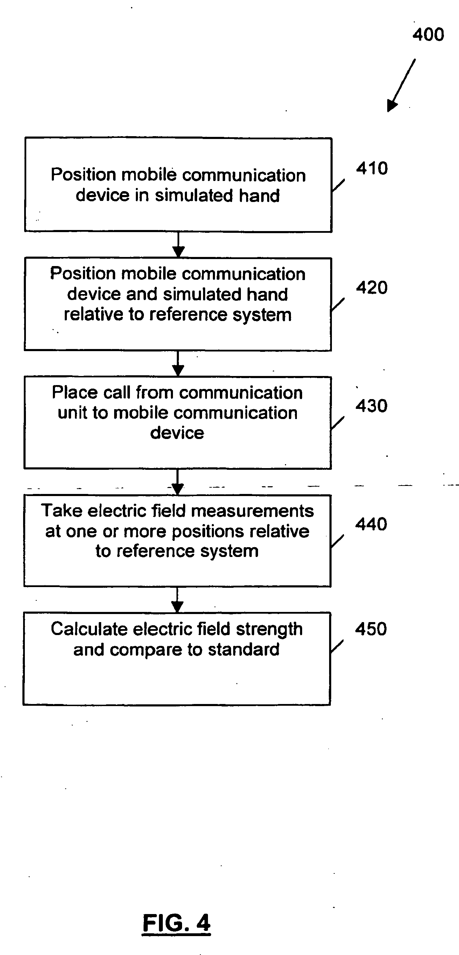

Referring now to FIG. 4, a method 400 of conducting SAR testing of mobile communication device 150 is described in further detail. Method 400 begins at step 410, at which mobile communication device 150 is positioned in simulated hand 160 in the manner depicted in FIG. 2.

As much as possible, the mobile communication device 150 is to be positioned in simulated hand 160 in a manner that mimics the way that mobile communication device 150 would be held in a user's hand when its audio output (speaker) is held to the user's ear. For example, mobile communication device 150 may be held in simulated hand 160 so that the palm of simulated hand 160 supports the backside (i.e. the face opposite to the display screen and dialing keys) of mobile communication device 150, while a thumb of simulated hand 160 is positioned along a right-side of mobile communication device 150 and the third, fourth and fifth digits of the simulated hand 160 are positioned along and/or around the left side of mobile communication device 150. The second digit (pointer finger) may be positioned over, around or along a top edge of mobile communication device 150, proximally adjacent the audio output, or it may be positioned along the left side of the device with the third, fourth and fifth digits. This example assumes that simulated hand 160 is a right hand. It will be understood that an opposite orientation of the digits of simulated hand 160 relative to mobile communication device 150 may be employed for a left-handed version of simulated hand 160. Simulated hand 160 may be formed differently to accommodate different ways of holding mobile communication device 150, for example because of different user interface features and/or device shapes or sizes.

At step 420, mobile communication device 150 is positioned relative to simulated head 170, as shown in FIG. 2, by moving simulated hand 160 and support stand 162 so that the audio output of mobile communication device 150 is positioned directly and closely beneath simulated head 170 proximate the communication device reference markers of the reference system 220.

At step 430, communication unit 130 is manually caused to place a call (line 135) to mobile communication device 150, thereby creating wireless connection between communication unit 130 and mobile communication device.

In placing the call to mobile communication device 150, communication unit 130 transmits a test signal recognized by mobile communication device 150 to cause it to transmit a communication signal at full power.

At step 440, in accordance with its programming, measurement controller 105 causes probe positioning system 115 to move probe 120 to one or more positions relative to the indicia 222 (and consequently to the simulated head 170 and the communication device 150) in sequence and to take electric field measurements at those positions. Such electric field measurements are received at measurement controller 105 via receiver 125.

At step 450, measurement controller 105 calculates the electric field strengths at the predetermined positions, based on the measurements obtained at step 440. Measurement controller 105 then compares the calculated field strengths to a standard to determine whether mobile communication device 150 meets the SAR testing requirements.

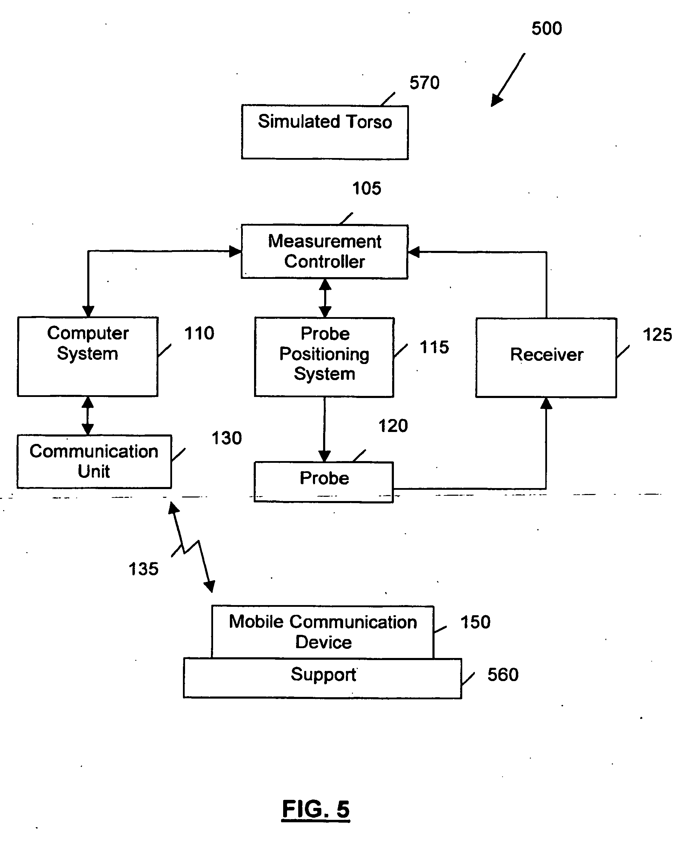

Referring now to FIG. 5, there is shown a system 500 for conducting SAR testing according to further embodiments. System 500 is similar to system 100, except that the simulated hand 160 is replaced by a support 560, and the simulated head 170 is replaced by a simulated torso 570. As will be understood from the discussion below, the combination of the support 550 and simulated torso 570 are intended to simulate a mobile device 150 in a belt holster, pocket or otherwise supported in position near a person's torso. Accordingly, for succinctness of description, only the differences between systems 100 and 500 are described below.

The simulated torso 570 is may comprise the mid-section of the tank 200 (see FIG.2), which is shaped substantially like a human torso. The liquid 202 in the tank 200 may be any suitable liquid having substantially uniform dielectric properties, including dielectric constant and conductivity, that approximate the average dielectric properties of a human torso, including bone and other tissue. The particular characteristics and proportions of such ingredients of liquids suitable for simulating torso tissue will be known to those skilled in the art of SAR testing, as will suitable methods of preparation of such liquids. Liquid 202 will typically comprise the same liquid as used for the testing system 100 when the simulated head 170 is to be used. The reference system 220 also includes communication device reference markers (not shown) for precisely positioning the communication device 150 relative to the torso 570, as will be understood.

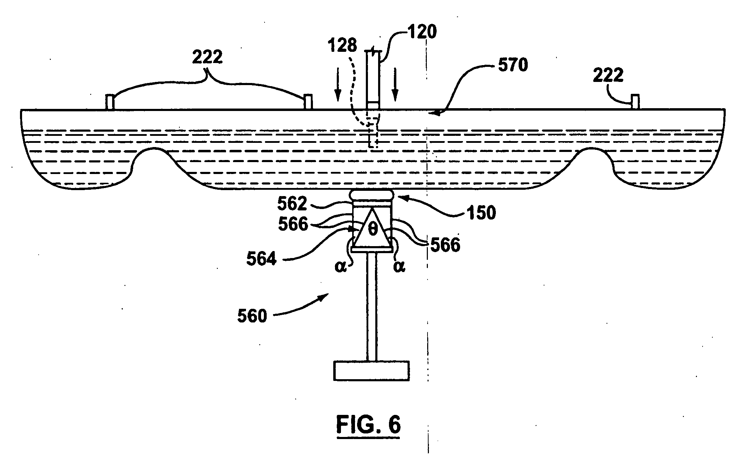

As illustrated in FIG. 6, the support 560 comprises a substantially rectangular platform 562, upon which the communication device 150 may be positioned. The dimensions of the platform 562 preferably approximate the dimensions of the rear side of the device 150. The platform 562 comprises a material having a low dielectric constant, such as Styrofoam, and of sufficient thickness and resiliency to support the device 150. The platform 562 rests on a platform support 564 comprising a plurality of four substantially vertical wall members 566 in angular relationship to each other. The wall members 566 substantially form a "W" shape in cross-section and may be formed of a single piece of material. The angle θ formed by the intersection of the centre wall members 566 is within a range of 20° - 120°, while the angle α formed by the intersection of the outer two wall members 566 on each side, is within a range of 10° - 60°. The platform support 564 is formed of sufficiently resilient and durable material also selected to have a low dielectric constant.

In order to minimize the effect on the field generated by the communication device 150, the configuration of the platform support 564 is selected to provide a small horizontal "footprint" relative to that of the platform 562, while still providing sufficient support to the platform 562. Accordingly, the horizontal surface area of the platform support 564 in contact with the platform 562, is 40% or less of the horizontal surface area of the platform 562. In an alternative configuration, the platform support 564 may include a plurality of vertical columns or spikes arrayed to provide sufficient support to the platform 562 to support a communication device 150. With such alternative configuration, the surface area of the spikes is again selected to be less than 40% of the horizontal surface area of the platform 562.

The support 560 also comprises a stand 568 of low dielectric constant material, but of sufficient strength and durability to physically support the entire support 560. The stand 568 is provided with a height adjustment mechanism, such as a telescoping neck, for example, to enable the vertical height adjustment of the communication device 150 relative to the underside of the simulated torso 570.

During SAR testing using simulated torso 570, mobile communication device 150 with or without a body worn accessory such as a holster is positioned below the torso 570, while supported by support 560. Thus, mobile communication device 150 is positioned between (a side of a) simulated torso 570 and support 560 in a manner that mimics the position of mobile communication device 150 when held in a belt holster on a person's waist.

As shown in FIG. 6, probe 120 is positioned relative to mobile communication device 150 by lowering probe 120 down into simulated torso 570 so that probe tip 128 can be positioned at specific positions relative to the mobile communication device 150, for SAR testing. The scan area or volume traced by the probe tip 128 covers the dimensions of the communication device 150.

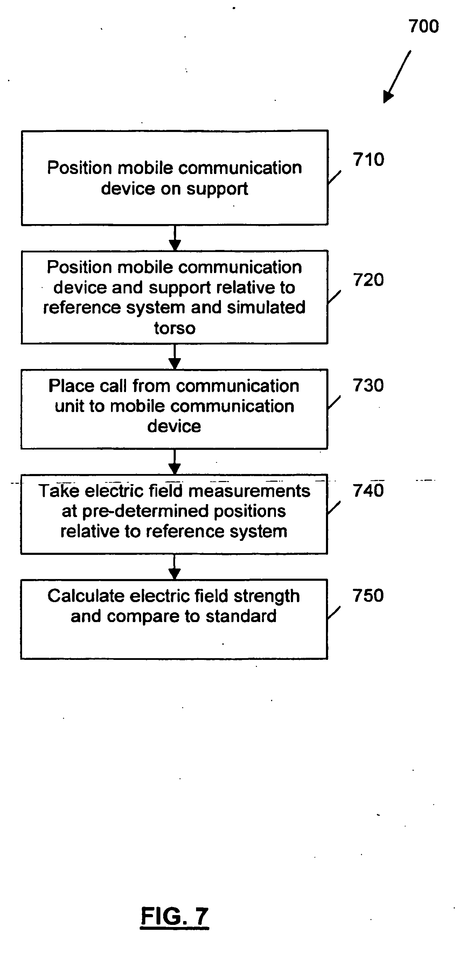

Referring now to FIG. 7, a method 700 of conducting SAR testing using simulated torso 570 is described. Method 700 begins at step 710, at which mobile communication device 150 is positioned on support 560 in the manner depicted in FIG. 6.

At step 720, mobile communication device 150 is positioned relative to simulated torso 570, as shown in FIG. 6, by moving support 560 so that the mobile communication device 150 is positioned directly and closely beneath the simulated torso 570 and proximate the communication device reference markers of the reference system 220. Steps 710 and 720 may be performed manually or automatically.

At step 730, a call is established between communication unit 130 and mobile communication device 150 manually, thereby creating a wireless connection (link 135) between communication unit 130 and mobile communication device 150. In placing the call to mobile communication device 150, communication unit 130 transmits a test signal recognized by mobile communication device 150 to cause it to transmit a communication signal at full power.

At step 740, in accordance with its programming, measurement controller 105 causes probe positioning system 115 to move probe 120 to one or more positions relative to the indicia 222 (and consequently to the simulated torso 570 and the communication device 150) in sequence and to take electric field measurements at those positions. Such electric field measurements are received at measurement controller 105 via receiver 125.

At step 750, measurement controller 105 calculates the electric field strengths at the various positions, based on the measurements obtained at step 740. Measurement controller 105 then compares the calculated field strengths to a standard to determine whether mobile communication device 150 meets the SAR testing requirements.

Use of simulated head 170 in addition to simulated hand 160 in conducting SAR testing may reduce uncertainty levels associated with the measurements obtained by the SAR testing. As well, use of support 560 with the simulated torso 570 in conducting SAR testing may reduce uncertainty levels associated with the measurements obtained by the SAR testing.

While the above description provides examples of embodiments, it will be appreciated that some features and/or functions of the described elements are susceptible to modification without departing from the spirit and principles of operation of the described embodiments. Accordingly, what has been described is intended to be illustrative of the invention and non-limiting.

## Claims

1. A system for conducting specific absorption rate testing of a mobile communication device (150), comprising:

    a simulated human body part (170; 570);
    a support (160; 560) positioned proximate to the simulated human body part (170; 570) for supporting the mobile communication device (150) during the testing;
    wherein the support (560) comprises a platform (562) mounted to a platform support (564), and wherein the surface area of the platform support (564) in contact with the platform is no greater than 40% of the horizontal surface area of the platform (562);
    a probe (120) positioned within the simulated human body part (170; 570); and
    a processor (105) operatively coupled to the probe (120) and configured to determined a field strength of a field within the simulated human body part (170; 570), the field radiated by the mobile communication device (150).

2. The system of claim 1, wherein the field comprises any of: an electric field, a microwave frequency field or a radio frequency field and the probe (120) is configured for sensing a respective one of an electric field, a microwave frequency field or a radio frequency field.

3. The system of claims 1 or claim 2, further comprising a communication unit (130) configured to communicate with the mobile communication device (150) and to cause the mobile communication device (150) to radiate the field.

4. The system of any one of claims 1 to 3, wherein the simulated human body part comprises a simulated head (170) and the simulated head (170) is positioned proximate the mobile communication device (150) and on an opposite side of the mobile communication device (150) to the support (560).

5. The system of claims 4, wherein the platform (562) comprises a material having a low dielectric constant.

6. The system of claim 4 wherein the simulated head (170) comprises a material (202) having a dielectric constant approximating an average dielectric constant of a human head.

7. The system of claim 5 or claim 6, wherein the material (202) comprises a liquid.

8. The system of any one of claims 4 to 7, wherein the head (170) is configured in a shape simulating that of a human head.

9. The system of any one of claims 1 to 3, wherein the simulated human body part is a simulated torso (570) comprising a material (202) having dielectric properties approximating average dielectric properties of a human torso.

10. The system of any one of claims 1 to 9, wherein the platform support (564) comprises a plurality of substantially vertical wall members (566) in angular relationship to each other.

11. The system of any one of claims 1 to 10, wherein the wall members (566) substantially form a "W" shape in cross-section.

12. The system of any one of claims 1 to 11, wherein the wall members (566) include centre wall members (566) and wherein the intersection of the centre wall members (566) forms an angle θ within a range of 20 ° to 120 °.

13. The system of any one of claims 1 to 11, wherein the wall members (566) include intersecting outer two wall members (566) on each side, and wherein the intersection of the outer two wall members (566) forms an angle α within a range of 10 ° to 60 °.

14. The system of any one of claims 1 to 9, wherein the platform support (564) comprises a plurality of vertical columns.

15. The system of any one of claims 1 to 9, wherein the platform support (564) comprises a plurality of vertical spikes.

## Patentansprüche

1. System zum Durchführen von Prüfungen der spezifischen Absorptionsrate bei einer mobilen Kommunikationsvorrichtung (150), umfassend:

einen simulierten menschlichen Körperteil (170; 570);

eine Halterung (160; 560), die in der Nähe des simulierten menschlichen Körperteils (170; 570) angeordnet ist, um die mobile Kommunikationsvorrichtung (150) während der Prüfung zu halten;

wobei die Halterung (560) eine Plattform (562) umfasst, die an eine Plattformhalterung (564) montiert ist, und wobei die Oberfläche der Plattformhalterung (564), die mit der Plattform in Berührung kommt, nicht größer ist als 40 % der horizontalen Oberfläche der Plattform (562);

einen Messfühler (120), der in dem simulierten menschlichen Körperteil (170; 570) angeordnet ist; und

einen Prozessor (105), der operativ mit dem Messfühler (120) verbunden und dafür ausgelegt ist, eine Feldstärke eines Feldes innerhalb des simulierten menschlichen Körperteils (170; 570) zu messen, wobei das Feld von der mobi-len Kommunikationsvorrichtung (150) abge-strahlt wird.

2. System nach Anspruch 1, wobei das Feld eines der folgenden umfasst: ein elektrisches Feld, ein Mikrowellen-Frequenzfeld oder ein Hochfrequenzfeld, und der Messfühler (120) dafür ausgelegt ist, ein jeweiliges von einem elektrischen Feld, einem Mikrowellen-Frequenzfeld oder einem Hochfrequenzfeld zu erkennen.

3. System nach Anspruch 1 oder Anspruch 2, ferner umfassend eine Kommunikationseinheit (130), die dafür ausgelegt ist, mit der mobilen Kommunikationsvorrichtung (150) zu kommunizieren und die mo-bile Kommunikationsvorrichtung (150) zu veranlas-sen, das Feld abzustrahlen.

4. System nach einem der Ansprüche 1 bis 3, wobei der simulierte menschliche Körperteil einen simulierten Kopf (170) umfasst und der simulierte Kopf (170) nahe der mobilen Kommunikationsvorrichtung (150) und an einer der Halterung (560) gegenüberliegenden Seite der mobilen Kommunikationsvorrichtung (150) angeordnet ist.

5. System nach Anspruch 4, wobei die Plattform (562) ein Material mit einer niedrigen dielektrischen Konstante umfasst.

6. System nach Anspruch 4, wobei der simulierte Kopf (170) ein Material (202) mit einer dielektrischen Konstante enthält, welche einer durchschnittlichen dielektrischen Konstante eines menschlichen Kopfes angenähert ist.

7. System nach Anspruch 5 oder Anspruch 6, wobei das Material (202) eine Flüssigkeit umfasst.

8. System nach einem der Ansprüche 4 bis 7, wobei der Kopf (170) in einer Form ausgebildet ist, die der-jenigen eines menschlichen Kopfes nachempfun-den ist.

9. System nach einem der Ansprüche 1 bis 3, wobei der simulierte menschliche Körperteil ein simulierter Torso (570) ist, der ein Material (202) mit dielektrischen Eigenschaften enthält, welche den durchschnittlichen dielektrischen Eigenschaften eines menschlichen Torsos angenähert sind.

10. System nach einem der Ansprüche 1 bis 9, wobei die Plattformhalterung (564) eine Mehrzahl von im Wesentlichen vertikalen Wandelementen (566) umfasst, die in einer Winkelbeziehung zueinander stehen.

11. System nach einem der Ansprüche 1 bis 10, wobei die Wandelemente (566) im Wesentlichen einen "W"-förmigen Querschnitt bilden.

12. System nach einem der Ansprüche 1 bis 11, wobei die Wandelemente (566) Mittelwandelemente (566) umfassen und wobei die Kreuzung der Mittelwandelemente (566) einen Winkel θ in einem Bereich von 20° bis 120° bildet.

13. System nach einem der Ansprüche 1 bis 11, wobei die Wandelemente (566) zwei einander kreuzende Außenwandelemente (566) an jeder Seite umfassen und wobei die Kreuzung der beiden Außenwandelemente (566) einen Winkel α in einem Bereich von 10° bis 60° bildet.

14. System nach einem der Ansprüche 1 bis 9, wobei die Plattformhalterung (564) eine Mehrzahl von vertikalen Säulen umfasst.

15. System nach einem der Ansprüche 1 bis 9, wobei die Plattformhalterung (564) eine Mehrzahl vertikaler Stifte umfasst.

**Revendications**

1. Un système pour mener un test de taux d'absorption spécifique d'un dispositif de communication mobile (150), comportant :

une partie du corps humain simulée (170 ; 570) ;
un support (160 ; 560) positionné à proximité de la partie du corps humain simulée (170 ; 570) pour supporter le dispositif de communication mobile (150) durant le test ;

où le support (560) comporte une plateforme (562) montée sur un support de plateforme (564), et où la superficie du support de plateforme (564) en contact avec la plateforme n'est pas supérieure à 40 % de la superficie horizontale de la plateforme (562) ;

une sonde (120) positionnée à l'intérieur de la partie du corps humain simulée (170 ; 570) ; et

un processeur (105) couplé de façon opérante à la sonde (120) et configuré pour déterminer une intensité de champ d'un champ à l'intérieur de la partie du corps humain simulée (170 ; 570), le champ étant rayonné par le dispositif de communication mobile (150).

2. Le système de la revendication 1, dans lequel le champ comporte n'importe quel élément parmi : un champ électrique, un champ hyperfréquence ou un champ radiofréquence et la sonde (120) est configurée pour capter un élément respectif parmi un champ électrique, un champ hyperfréquence ou un champ radiofréquence.

3. Le système de la revendication 1 ou de la revendication 2, comportant de plus une unité de communication (130) configurée pour communiquer avec le dispositif de communication mobile (150) et pour amener le dispositif de communication mobile (150) à rayonner le champ.

4. Le système de n'importe laquelle des revendications 1 à 3, dans lequel la partie du corps humain simulée comporte une tête simulée (170) et la tête simulée (170) est positionnée à proximité du dispositif de communication mobile (150) et d'un côté opposé du dispositif de communication mobile (150) par rapport au support (560).

5. Le système de la revendication 4, dans lequel la plateforme (562) comporte un matériau ayant une constante diélectrique basse.

6. Le système de la revendication 4, dans lequel la tête simulée (170) comporte un matériau (202) ayant une constante diélectrique se rapprochant d'une constante diélectrique moyenne d'une tête humaine.

7. Le système de la revendication 5 ou de la revendication 6, dans lequel le matériau (202) comporte un liquide.

8. Le système de n'importe laquelle des revendications 4 à 7, dans lequel la tête (170) est configurée dans une forme simulant celle d'une tête humaine.

9. Le système de n'importe laquelle des revendications 1 à 3, dans lequel la partie du corps humain simulée est un torse simulé (570) comportant un matériau (202) ayant des propriétés diélectriques se rapprochant des propriétés diélectriques moyennes d'un torse humain.

10. Le système de n'importe laquelle des revendications 1 à 9, dans lequel le support de plateforme (564) comporte une pluralité de membres de paroi essentiellement verticaux (566) en relation angulaire les uns par rapport aux autres.

11. Le système de n'importe laquelle des revendications 1 à 10, dans lequel les membres de paroi (566) forment essentiellement une forme en « W » en coupe transversale.

12. Le système de n'importe laquelle des revendications 1 à 11, dans lequel les membres de paroi (566) comprennent des membres de paroi centraux (566) et dans lequel l'intersection des membres de paroi centraux (566) forme un angle θ allant de 20° à 120°.

13. Le système de n'importe laquelle des revendications 1 à 11, dans lequel les membres de paroi (566) comprennent deux membres de paroi externes se coupant (566) de chaque côté, et dans lequel l'intersection des deux membres de paroi externes (566) forme un angle α allant de 10° à 60°.

14. Le système de n'importe laquelle des revendications 1 à 9, dans lequel le support de plateforme (564) comporte une pluralité de colonnes verticales.

15. Le système de n'importe laquelle des revendications 1 à 9, dans lequel le support de plateforme (564) comporte une pluralité de pointes verticales.

100

170

Simulated Head

105

Measurement
Controller

Computer
System    110

Probe
Positioning
System    115

Receiver    125

Communication
Unit    130

120

Probe

135

Mobile Communication
Device    150

Simulated Hand    160

**FIG. 1**

EP 1 986 453 B1

**FIG. 2**

**FIG. 3**

EP 1 986 453 B1

400

Position mobile communication
device in simulated hand

410

Position mobile communication
device and simulated hand
relative to reference system

420

Place call from communication
unit to mobile communication
device

430

Take electric field measurements
at one or more positions relative
to reference system

440

Calculate electric field strength
and compare to standard

450

## FIG. 4

**FIG. 5**

**FIG. 6**

700

```
┌─────────────────────────────┐
│   Position mobile communication  │   710
│        device on support         │
└─────────────────────────────┘
              │
              ▼
┌─────────────────────────────┐
│   Position mobile communication  │
│   device and support relative to │   720
│  reference system and simulated  │
│             torso                │
└─────────────────────────────┘
              │
              ▼
┌─────────────────────────────┐
│   Place call from communication  │   730
│     unit to mobile communication │
│             device               │
└─────────────────────────────┘
              │
              ▼
┌─────────────────────────────┐
│  Take electric field measurements│   740
│     at pre-determined positions  │
│     relative to reference system │
└─────────────────────────────┘
              │
              ▼
┌─────────────────────────────┐
│  Calculate electric field strength│  750
│     and compare to standard      │
└─────────────────────────────┘
```

## FIG. 7